# EUROPÄISCHE PATENTSCHRIFT

(11) **EP 0 567 815 B1**
(45) Veröffentlichungstag und Bekanntmachung des Hinweises auf die Patenterteilung: **15.07.1998**
(21) Anmeldenummer: 93105780.6
(22) Anmeldetag: 07.04.1993
(51) Int. Cl.: H01L 21/28, H01L 21/768, H01L 21/285, H01L 21/321

(54) **Verfahren zur Herstellung eines Kontaktlochs zu einem dotierten Bereich**
Method of making a contact hole to a doped region
Procédé de fabrication d'un trou de contact sur une région dopée

(30) Priorität: 29.04.1992 DE 4214123
(43) Veröffentlichungstag der Anmeldung: 03.11.1993
(73) Patentinhaber: SIEMENS AKTIENGESELLSCHAFT, 80333 München (DE)
(72) Erfinder: Winnerl, Josef, Dr., W-8000 München 81 (DE); Neumüller, Walter, Dipl.-Phys., W-8000 München 22 (DE)

(56) Entgegenhaltungen:
- FR-A- 2 143 126
- IEEE TRANSACTIONS ON ELECTRON DEVICES Bd. 35, Nr. 10 , Oktober 1987 , NEW YORK US Seiten 1601 - 1608 Y.YAMAMOTO ET AL. 'SDX : A NOVEL SELF-ALIGNED TECHNIQUE AND ITS APPLICATION TO HIGH-SPEED BIPOLAR LSI'S'
- INTERNATIONAL ELECTRON DEVICES MEETING 6. Dezember 1987 , WASHINGTON,D.C. Seiten 32 - 35 Y.MISAWA ET AL. 'A SELF-ALIGNING POLYSILICON ELECTRODE TECHNOLOGY (SPEL) FOR FUTURELSIS'
- PATENT ABSTRACTS OF JAPAN vol. 8, no. 41 (C-211)22. Februar 1984 & JP-A-58 199 869 (MATSUSHITA DENKI SANGYO KK) 21. November 1983

## Beschreibung

Bei der Herstellung integrierter Schaltungen wird nach Fertigstellung der einzelnen Bauelemente, meist MOS-Transistoren, mindestens eine Verdrahtungsebene gebildet, die die Bauelemente untereinander verbindet.

Bei konventionellen Technologien wird dazu eine relativ dicke isolierende Schicht, meist aus Siliziumoxid mit Zusätzen, abgeschieden. Durch diese isolierende Schicht werden mit Hilfe einer Photolackmaske anisotrop, das heißt mit senkrechter Vorzugsrichtung, Kontaktlöcher durchgeätzt bis zu den zu kontaktierenden Bereichen der Bauelemente. Zu kontaktieren sind unter anderem Gates oder dotierte Bereiche der Transistoren. Es wird eine Metallisierung, zum Beispiel eine AlSiCu-Legierung abgeschieden. Die Metallisierung füllt die Kontaktlöcher auf und bildet an der Oberfläche der isolierenden Schicht eine durchgehende Schicht. Diese wird strukturiert zur Fertigstellung der Verdrahtungsebene.

In dieser Prozeßfolge müssen die Kontaktlöcher so plaziert werden, daß jeweils ein Sicherheitsabstand zwischen dem Ort des Kontaktlochs und benachbarten leitenden Bereichen im oder an der Oberfläche des Substrats gewahrt wird. Insbesondere bei der Kontaktierung dotierter Bereiche eines MOS-Transistors muß zur Vermeidung von Kurzschlüssen ein Sicherheitsabstand zu benachbarten Gateelektroden gewahrt werden. Dieser muß so groß sein, daß er die unvermeidlichen Prozeß- und Justiertoleranzen sicher abfängt. Dieser Sicherheitsabstand verursacht einen Platzverlust, der sich bei miniaturisierten integrierten Schaltungen mit extremer Packungsdichte, zum Beispiel DRAM's, besonders störend auswirkt.

Verfahren, die diesen Nachteil vermeiden, sind aus der Literatur bekannt.

Aus K. H. Küsters et al., Sympos. on VLSI Technology, 1987, Tech. Digest p. 93 ff ist bekannt, die Gateelektroden vor der Abscheidung der dicken isolierenden Schicht mit einer isolierenden Deckschicht und isolierenden Flankenbedeckungen, sogenannten Spacern, einzuhüllen. Anschließend wird eine dünne Hilfsschicht zum Beispiel aus Siliziumnitrid abgeschieden. Danach wird die dicke isolierende Schicht abgeschieden, in der die Kontaktlöcher geöffnet werden. Dabei wirkt die Hilfsschicht als Ätzstopp. In den geöffneten Kontaktlöchern wird die Hilfsschicht anschließend selektiv zum Substrat und zur die Gateelektroden umhüllenden Isolation abgeätzt. Bei diesem Verfahren können die Kontaktlöcher überlappend zu den Gateelektroden gesetzt werden. In diesem Verfahren ist eine hohe Ätzselektivität von Siliziumnitrid zu der die Gateelektroden umhüllenden Isolation, meist Siliziumoxid erforderlich.

Ein weiteres Verfahren ist aus K. H. Küsters et al., ESSDERC 1988, Journal de Physique, p. 503 ff bekannt, das bei nicht ausreichender Ätzselektivität von Siliziumnitrid zu Oxid eingesetzt werden kann. In diesem Verfahren wird über der Hilfsschicht aus Siliziumnitrid zusätzlich eine dünne Schicht aus Polysilizium abgeschieden. Nach der Kontaktlochätzung durch die dicke isolierende Schicht, bei der die dünne Polysiliziumschicht als Ätzstopp wirkt, wird zunächst das Polysilizium selektiv zum Siliziumnitrid und dann das Siliziumnitrid selektiv zum Substrat geätzt.

Außerhalb der Kontaktbereiche wird später die unter der isolierenden Schicht verbliebene Polysiliziumschicht durch eine geeignete Temperung in O₂-Atmosphäre aufoxidiert. Dieser Prozeßschritt ist sehr problematisch.

Bei beiden bekannten Verfahren werden Hilfsschichten eingesetzt, die im Kontaktlochbereich wieder vollständig entfernt werden müssen.

In den beiden bekannten Verfahren ist es prinzipiell unmöglich, gleichzeitig Kontaktlöcher zu dotierten Bereichen im Substrat, Source/Drain-Bereichen, und zu Gateelektroden aus Polysilizium zu öffnen. Die Kontaktlöcher zu den Gateelektroden müssen nach der Siliziumnitridätzung geöffnet werden.

Der Erfindung liegt das Problem zugrunde, ein weiteres Verfahren zur Herstellung eines Kontaktloches zu einem dotieren Bereich anzugeben, das die Entfernung von Hilfsschichten im Kontaktbereich vermeidet und das insbesondere dazu geeignet ist, gleichzeitig Kontaktlöcher zu Source/Drain-Gebieten und Gateelektroden zu öffnen.

Das Problem wird erfindungsgemäß gelöst durch ein Verfahren nach Anspruch 1. Weitere Ausgestaltungen der Erfindung gehen aus den übrigen Ansprüchen hervor.

In dem erfindungsgemäßen Verfahren wird ausgenutzt, daß undotiertes Silizium selektiv zu dotiertem Silizium entfernt werden kann. Die undotierte Siliziumschicht, die zum Beispiel amorph ist, wird durch Ionenimplantation unter Verwendung einer Maske selektiv im Bereich des späteren Kontaktes dotiert. Anschließend werden die undotierten Teil der Siliziumschicht selektiv zu dem dotierten Gebiet entfernt. Es wird ganzflächig eine Isolationsschicht erzeugt, in der das Kontaktloch durch anisotropes Ätzen selektiv zu dem dotierten Gebiet der Siliziumschicht geöffnet wird. Das dotierte Gebiet der Siliziumschicht wirkt dabei als Ätzstop. Die als Hilfsschicht eingeführte Siliziumschicht braucht im Bereich des Kontaktloches nicht mehr entfernt werden.

Es ist besonders vorteilhaft, die Siliziumschicht so zu erzeugen, daß sie mindestens in dem dotierten Gebiet aus Polysilizium besteht, da Siliziumoxid, das die Isolationsschicht in der Regel im wesentlichen enthält, mit hoher Selektivität zu Polysilizium ätzbar ist.

Die im Stand der Technik erforderliche, problematische nachträgliche Aufoxidation der Siliziumschicht entfällt, da die undotierten Teile der Siliziumschicht außerhalb des Kontaktlochs entfernt werden.

Durch Einstellung einer hohen Dotierung in dem dotierten Gebiet der Siliziumschicht ist eine gut leitende, ausgedehnte Kontaktfläche an der Oberfläche des dotierten Bereichs, der kontaktiert werden soll, vorhanden. Dadurch sind geringe Anschlußwiderstände für die durch eine das Kontaktloch auffüllende Metallisierung gebildeten Kontakte erzielbar.

Das Verfahren ermöglicht eine gleichzeitige Öffnung von Kontaktlöchern zu Gateelektroden aus Polysilizium. Besteht die isolierende Deckschicht der Gateelektroden und die Isolationsschicht im wesentlichen aus Siliziumoxid, so wirkt bei der Kontaktlochätzung im Bereich der Gateelektrode das Polysilizium der Gateelektrode als Ätzstopp und im Bereich des dotierten Bereichs das dotierte Gebiet der Siliziumschicht als Ätzstopp.

Im folgenden wird die Erfindung anhand eines Ausführungsbeispiels und der Figuren näher erläutert.
- Figur 1: zeigt ein Substrat, in dem MOS-Transistoren hergestellt sind, an dessen Oberfläche eine Siliziumschicht erzeugt ist.
- Figur 2: zeigt die selektive Dotierung der Siliziumschicht.
- Figur 3: zeigt das den Kontaktlochbereich 4 überlappende, dotierte Gebiet der Siliziumschicht.
- Figur 4: zeigt das Kontaktloch in der Isolationsschicht.

In einem Substrat 1 aus zum Beispiel einkristallinem Silizium sind dotierte Bereiche 2 angeordnet. Die dotierten Bereiche 2 sind zum Beispiel Source- oder Drain-Gebiete von MOS-Transistoren. Sie sind zum Beispiel p-dotiert.

An der Oberfläche des Substrats 1 sind zwischen zwei dotierten Bereichen 2, die als Source- und Drain-Gebiet wirken, Gateelektroden 3 aus dotiertem Polysilizium angeordnet. Die Gateelektroden 3 sind mit einer isolierenden Deckschicht 4 aus zum Beispiel SiO₂ versehen. An den Flanken der Gateelektroden 3 und der isolierenden Deckschicht 4 sind Spacer 5 angeordnet, die ebenfalls zum Beispiel aus SiO₂ bestehen.

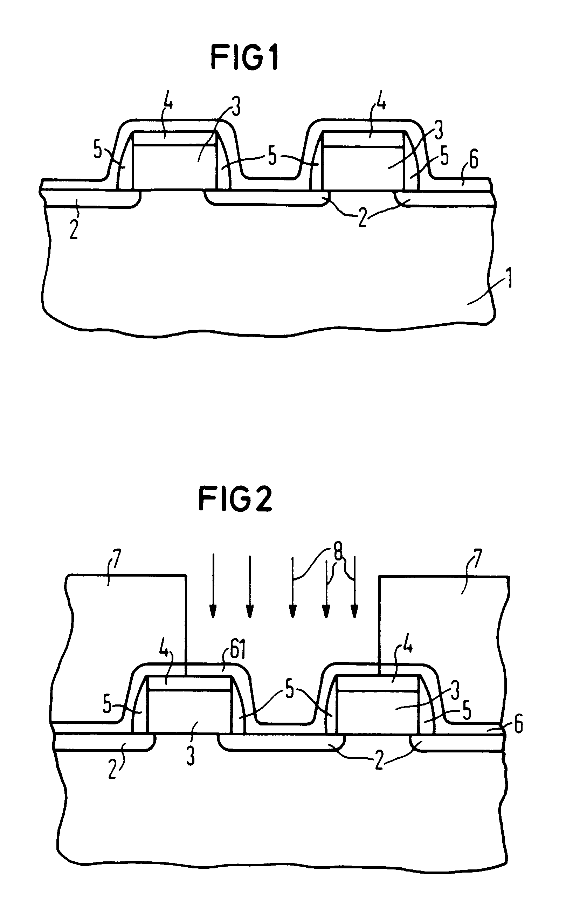

Es wird ganzflächig eine Siliziumschicht 6 erzeugt, die die freiliegenden Oberflächen der dotierten Bereiche 2 und die Oberflächen der isolierenden Deckschichten 4 und der Spacer 5 bedeckt. Die Siliziumschicht 6 wird amorph oder polykristallin abgeschieden. Die Siliziumschicht 6 ist undotiert (siehe Figur 1).

Es wird eine Photolackmaske 7 hergestellt, die ein Gebiet der Siliziumschicht 6, das die Ausdehnung des späteren Kontaktloches sicher überlappt, unbedeckt läßt. Unter Verwendung der Photolackmaske 7 als Implantationsmaske wird durch Implantation mit zum Beispiel Bor, angedeutet durch die Pfeile 8, ein dotiertes Gebiet 61 der Siliziumschicht hergestellt. Die Implantation erfolgt zum Beispiel mit einer Ionenenergie von 10 keV und einer Teilchendichte von 10¹⁵ cm⁻² (siehe Figur 2).

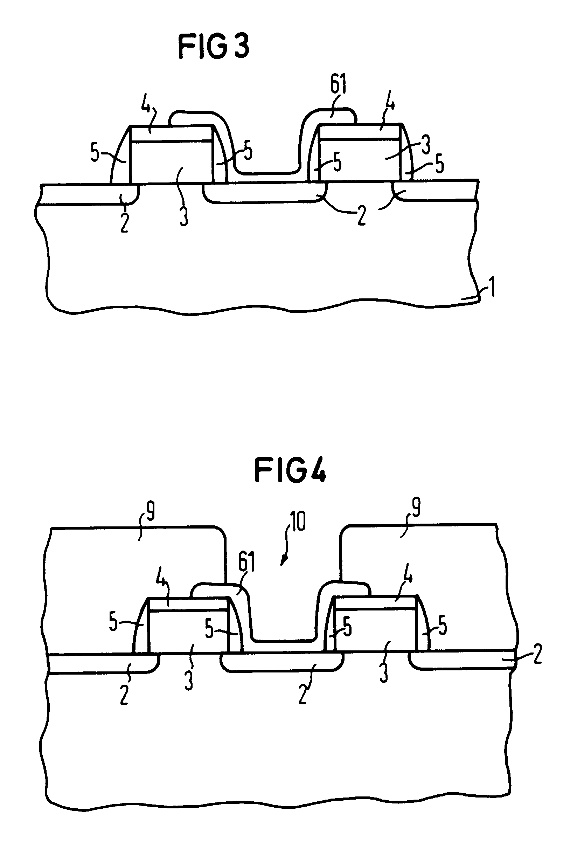

Nach Entfernen der Photolackmaske 7 wird durch selektives naßchemisches Ätzen mit Kalium-Hydroxid-Lösung der undotierte Teil der Siliziumschicht 6 selektiv zum dotierten Gebiet 61 entfernt (siehe Figur 3).

Nach ganzflächigem Aufbringen einer Isolationsschicht 9, die zum Beispiel im wesentlichen aus SiO₂ besteht, wird unter Verwendung einer weiteren Photolackmaske (nicht dargestellt) als Ätzmaske durch reaktives Ionenätzen mit zum Beispiel CF₆ ein Kontaktloch 10 geöffnet. Bei der Kontaktlochätzung wirkt das dotierte Gebiet 61 der Siliziumschicht als Ätzstopp (siehe Figur 4).

Wenn in dem gleichen Verfahren Kontaktlöcher zu den Gateelektroden geöffnet werden sollen, muß darauf geachtet werden, daß das dotierte Gebiet der Siliziumschicht den Bereich für das Kontaktloch zur Gateelektrode nicht überlappt. Das Kontaktloch zur Gateelektrode wird durch die Isolationsschicht und die isolierende Deckschicht hindurch geöffnet.

## Patentansprüche

1. Verfahren zur Herstellung eines Kontaktloches in einer Isolationsschicht über einem Source/Drain-Gebiet eines MOS-Transistors,
- bei dem für den MOS-Transistor in einem Substrat (1) zwei Source/Drain-Gebiete (2) und eine Gateelektrode (3) geformt werden, die mit isolierenden Flankenbedeckungen (5) und einer isolierenden Deckschicht (4), versehen werden,
- bei dem ganzflächig eine undotierte Siliziumschicht (6) abgeschieden wird,
- bei dem in der Siliziumschicht (6) durch Implantation unter Verwendung einer Maske (7) ein dotiertes Gebiet (61) über mindestens einem der zwei Source/Drain Gebiete erzeugt wird, das sich sicher über den Bereich des später zu erzeugenden Kontaktlochs (10) erstreckt,
- bei dem undotierte Teile der Siliziumschicht (6) selektiv zu dem dotierten Gebiet (61) entfernt werden,
- bei dem ganzflächig eine Isolationsschicht (9) erzeugt wird,
- bei dem das Kontaktloch (10) durch anisotropes Ätzen der Isolationsschicht selektiv zu dem dotierten Gebiet (61) der Siliziumschicht (6) in der Isolationsschicht (9) geöffnet wird, wobei das dotierte Gebiet (61) der Siliziumschicht als Ätzstop wirkt.

2. Verfahren nach Anspruch 1,
bei dem das Substrat (1) aus einkristallinem Silizium besteht.

3. Verfahren nach Anspruch 1 oder 2,
bei dem die Siliziumschicht (6) aus amorphem Silizium hergestellt wird.

4. Verfahren nach einem der Ansprüche 1 bis 3,
bei dem die undotierten Teile der Siliziumschicht (6) durch naßchemisches Ätzen entfernt werden.

5. Verfahren nach einem der Ansprüche 1 bis 4,
- bei dem die Source/Drain-Gebiete (2) im Substrat (10) p-dotiert sind,
- bei dem das dotierte Gebiet (61) der Siliziumschicht (6) p-dotiert wird,
- bei dem die undotierten Teile der Siliziumschicht (6) durch naßchemische Ätzung mit Kaliumhydroxidlösung entfernt werden,
- bei dem die Gateelektrode (3) aus Polysilizium gebildet wird,
- bei dem die isolierenden Flankenbedeckungen (5) und die isolierenden Deckschichten (4) aus Siliziumoxid gebildet werden.

6. Verfahren nach Anspruch 5,
bei dem in dem dotierten Gebiet (61) der Siliziumschicht (6) eine Borkonzentration zwischen 10¹⁸ cm⁻³ und 10²⁰ cm⁻³ eingestellt wird.

7. Verfahren nach Anspruch 5 oder 6,
- bei dem die Isolationsschicht (9), in der das Kontaktloch (10) geöffnet wird, SiO₂ enthält,
- bei dem gleichzeitig mit Öffnen des Kontaktloches (10) zu dem dotierten Bereich (2) ein weiteres Kontaktloch zur Gateelektrode (3) geöffnet wird.

## Claims

1. Method for the production of a contact hole in an insulation layer over a source/drain region of an MOS transistor,
- in which two source/drain regions (2) and a gate electrode (3), which are provided with insulating side coverings (5) and an insulating covering layer (4), are formed for the MOS transistor in a substrate (1),
- in which an undoped silicon layer (6) is deposited over the whole area,
- in which a doped zone (61) is produced, over at least one of the two source/drain regions, in the silicon layer (6) by means of implantation using a mask (7), which doped zone reliably extends over the region of the contact hole (10) to be produced later,
- in which undoped parts of the silicon layer (6) are removed selectively with respect to the doped zone (61),
- in which an insulation layer (9) is produced over the whole area,
- in which the contact hole (10) is opened in the insulation layer (9) by means of anisotropic etching of the insulation layer selectively with respect to the doped zone (61) of the silicon layer (6), the doped zone (61) of the silicon layer acting as etching stop.

2. Method according to Claim 1, in which the substrate (1) consists of monocrystalline silicon.

3. Method according to Claim 1 or 2, in which the silicon layer (6) is produced from amorphous silicon.

4. Method according to one of Claims 1 to 3, in which the undoped parts of the silicon layer (6) are removed by wet-chemical etching.

5. Method according to one of Claims 1 to 4
- in which the source/drain regions (2) in the substrate (1) are p-doped,
- in which the doped zone (61) of the silicon layer (6) is p-doped,
- in which the undoped parts of the silicon layer (6) are removed by means of wet-chemical etching using potassium hydroxide solution,
- in which the gate electrode (3) is formed from polysilicon,
- in which the insulating side coverings (5) and the insulating covering layers (4) are formed from silicon oxide.

6. Method according to Claim 5, in which a boron concentration of between 10¹⁸ cm⁻³ and 10²⁰ cm⁻³ is set in the doped zone (61) of the silicon layer (6).

7. Method according to Claim 5 or 6,
- in which the insulation layer (9), in which the contact hole (10) is opened, comprises SiO₂,
- in which a further contact hole to the gate electrode (3) is opened at the same time that the contact hole (10) to the doped region (2) is opened.

## Revendications

1. Procédé de fabrication d'un trou de contact dans une couche d'isolation au-dessus d'une zone de source/drain d'un transistor MOS,
- dans lequel deux régions de source/drain (2) et une électrode de grille (3) sont créées dans un substrat (1) pour le transistor MOS, ces régions étant dotées de recouvrements de flanc isolants (5) et d'une couche de recouvrement isolante (4),
- dans lequel une couche de silicium non dopée (6) est déposée sur toute la surface,
- dans lequel une région dopée (61) est créée par implantation sur au moins l'une des zones de source/drain dans la couche de silicium (6), avec l'utilisation d'un masque (7), cette région s'étendant sur la région du trou de contact (10) qui doit être créé ultérieurement,
- dans lequel des parties non dopées de la couche de silicium (6) sont enlevées sélectivement par rapport à la région dopée (61),
- dans lequel une couche d'isolation (9) est créée sur toute la surface,
- dans lequel le trou de contact (10) est percé dans la couche d'isolation (9) par gravure anisotrope de la couche d'isolation, de manière sélective par rapport à la région dopée (61) de la couche de silicium (6), la région dopée (61) de la couche de silicium faisant office de blocage de la gravure.

2. Procédé selon la revendication 1,
dans lequel le substrat (1) est constitué de silicium monocristallin.

3. Procédé selon la revendication 1 ou 2,
dans lequel la couche de silicium (6) est réalisée en silicium amorphe.

4. Procédé selon l'une des revendications 1 à 3,
dans lequel les parties non dopées de la couche de silicium (6) sont enlevées par gravure chimique humide.

5. Procédé selon l'une des revendications 1 à 4,
- dans lequel les zones de source/drain (2) sont dopées du type p dans le substrat (1).
- dans lequel la région dopée (61) de la couche de silicium (6) est dopée du type p,
- dans lequel les parties non dopées de la couche de silicium (6) sont enlevées par gravure chimique humide à l'aide d'une solution d'hydroxyde de potassium,
- dans lequel l'électrode de grille (3) est réalisée en polysilicium,
- dans lequel les recouvrements de flanc isolants (5) et les couches de recouvrement isolantes (4) sont réalisés en oxyde de silicium.

6. Procédé selon la revendication 5,
dans lequel une concentration de bore comprise entre 10¹⁸ cm⁻³ et 10²⁰ cm⁻³ est fixée dans la région dopée (61) de la couche de silicium (6).

7. Procédé selon la revendication 5 ou 6,
- dans lequel la couche d'isolation (9) dans laquelle le trou de contact (10) est percé contient du SiO₂,
- dans lequel, simultanément au percement du trou de contact (10) vers la région dopée (2), un autre trou de contact est percé vers l'électrode de grille (3).
